Europäisches Patentamt

European Patent Office

Office européen des brevets

(19)

(11) Publication number: **0 338 749**
**A2**

## (12) EUROPEAN PATENT APPLICATION

(21) Application number: **89303779.6**

(22) Date of filing: **17.04.89**

(51) Int. Cl.⁴: **G03F 1/00**

(30) Priority: **18.04.88 JP 95323/88**
**30.09.88 JP 243915/88**

(43) Date of publication of application:
**25.10.89 Bulletin 89/43**

(84) Designated Contracting States:
**DE FR GB NL**

(71) Applicant: **CANON KABUSHIKI KAISHA**
**30-2, 3-chome, Shimomaruko**
**Ohta-ku Tokyo(JP)**

(72) Inventor: **Fukuda, Yasuaki**
**493-7-4-305 Tsurumaki**
**Hadano-shi Kanagawa-ken(JP)**
Inventor: **Suzuki, Yumiko**
**1317 Kitakaname**
**Hiratsuka-shi Kanagawa-ken(JP)**
Inventor: **Shibata, Hirofumi**
**Nakata-copo 5-6-17-5 Toyookahachijo**
**Asahikawa-shi Hokkaido(JP)**

(74) Representative: **Beresford, Keith Denis Lewis**
**et al**
**BERESFORD & Co. 2-5 Warwick Court High**
**Holborn**
**London WC1R 5DJ(GB)**

(54) **Structure of X-ray mask.**

(57) An X-ray mask structure usable in X-ray lithography is disclosed. The mask structure includes an X-ray absorptive material formed into a desired pattern, a supporting film for supporting the absorptive material pattern and a holding frame for holding the supporting film. In order to attain a desired flatness of the supporting film with good efficiency and good precision, a topmost flat end face of the supporting frame is finished to a flatness t (micron) which, where an inner radius of the holding frame denoted by $\ell$ (mm), an inner radius of an absorptive material pattern region is denoted by r (mm) and a flatness required in the pattern region is denoted by $\alpha$ - (micron), satisfies a relationship: $\alpha < t \leq \ell/r \times \alpha$. In another aspect, the holding frame is provided with an inclined portion at its peripheral end portion as well as a groove formed in the inclined portion. The supporting film is adhered to the holding frame by using the groove.

F I G. 8

## STRUCTURE OF X-RAY MASK

### FIELD OF THE INVENTION AND RELATED ART

This invention relates to a mask structure for use in the manufacture of microcircuit devices such as semiconductor devices and, more particularly, to a mask structure suitably usable in an X-ray lithographic apparatus.

Many varieties of lithographic processes have been proposed and put into practice, for manufacture of electronic devices such as integrated circuits (ICs), large scaled integrated circuits (LSIs) and the like. Among these processes, X-ray lithography has a large number of advantages as compared with conventional lithographic processes using a visible light, a ultraviolet light or otherwise. This owes to the inherent property of X-rays such as, for example, high transmission factor (low absorption factor) and short wavelength. Thus, the X-ray lithography has become attractive as an effective submicron linewidth lithographic process.

Mask structure usable in such X-ray lithography is such that: X-ray absorptive material is formed in a desired pattern on one side surface of a supporting film showing X-ray transmissibility, and the supporting film is not adhered to an uppermost flat end face of a ring-like holding frame but is adhered, by an adhesive, to an inclined surface provided outside the flat end face and extending at a certain angle with respect to the flat end face. More particularly, the supporting film which supports the X-ray absorptive material is adhered to the inclined surface in a manner that a uniform tension is applied to the supporting film omnidirectionally from the center of the ring-like holding frame such that the supporting film is pressed against the uppermost flat end face. Thus, the flatness of the supporting film is substantially determined by the flatness of the uppermost flat end face.

As regard the flatness required for the supporting film, usually it is not greater than 1 micron within the area in which the X-ray absorptive material pattern is formed. Conventionally, in consideration thereof, the topmost flat end face of the frame is finished by super-precision lathe, lapping or otherwise so that the flat end face is formed into a flatness not greater than 1 micron. This necessitates a long time for the finishing and thus leads to deteriorated throughput.

Further, even if the topmost flat end face is finished with highest precision and if the supporting film is adhered to the frame of the mask, there is a possibility of peeling of a circumferential portion of the supporting film due to the repetition of mounting and dismounting of the mask and conveying of the same during practical use of the mask. If this occurs, only a minute peeling will grow into a large peeling due to the tension applied to the supporting film. This will result in flexure of the supporting film and, thus, in deterioration of the flatness of the supporting film.

In order to obviate this problem, it may be necessary to apply an adhesive of a sufficient amount to the holding frame to cover its outer peripheral portion for adhesion and fixation of the supporting film. However, if a large amount of adhesive is applied, any excessive adhesive easily spread out of the inside surface and outside surface of the ring-like frame, causing deterioration of the flatness of the supporting film. Also, when any unwanted adhesive at the periphery is set, it provides undesirable surface irregularities.

There is another problem that, during a process of forming a pattern of X-ray absorptive material upon the X-ray mask structure, dust or foreign particles can enter into a clearance between the supporting film and the topmost flat end face of the mask frame. This results in deterioration of the flatness of the supporting film.

### SUMMARY OF THE INVENTION

It is an object of the present invention to provide a method of fabricating, with a good efficiency, a high-precision X-ray mask structure having a desired flatness and also to provide an X-ray mask structure fabricated in accordance with that method.

It is another object of the present invention to provide an X-ray mask structure which is less deteriorated in flatness, despite repeated use thereof.

In accordance with one aspect of the present invention, there is provided an X-ray mask structure including an X-ray absorptive material formed in a desired pattern, a supporting film for supporting the absorptive material and a ring-like holding frame for holding both of them, wherein, when the inner radius of the ring-like holding frame is denoted by $\ell$ (mm), the inner radius of the pattern area in which the X-ray absorptive pattern is formed is denoted by r (mm) and the flatness required for the pattern area is denoted by $\alpha$ - (micron), the ring-like holding frame has a topmost flat end face having been finished to a flatness t (micron) for which the following relation is satisfied:
$$\alpha < t \leq \ell/r \cdot \alpha$$

In accordance with another aspect of the invention, a ring-like holding frame has an inclined portion formed in a region of a peripheral edge portion of the ring-like holding frame and being inclined radially outwardly and a groove formed in the inclined portion, wherein a supporting film as a lithographic mask is tensed and adhered to the holding frame by utilizing the inclined portion and the groove.

Particularly, in accordance with an aspect of the invention, the lithographic mask supporting film is tensed and adhered to the inclined portion and is fixed thereby and, additionally, a peripheral portion of the supporting film is partly inserted into the groove and is fixed thereto by using an adhesive applied thereto so as to cover that portion.

These and other objects, features and advantages of the present invention will become more apparent upon a consideration of the following description of the preferred embodiments of the present invention taken in conjunction with the accompanying drawings.

## BRIEF DESCRIPTION OF THE DRAWINGS

Figures 1 and 2 show an X-ray mask structure according to an embodiment of the present invention, wherein Figure 1 is a sectional view and Figure 2 is a top plan view.

Figure 3 is a graph showing the interrelation between a radius r of a pattern area of a supporting film and the flatness within that area, in an X-ray mask structure having a ring-like frame of an inner diameter of 80 mm.

Figure 4 is a graph showing the interrelation between a radius r of a pattern area of an X-ray mask structure, having a ring-like frame of different inner diameter, from that in the Figure 3 example, and the flatness $\alpha$ in that pattern area.

Figures 5 and 6 show an X-ray mask structure according to another embodiment of the present invention, wherein Figure 5 is a sectional view and Figure 6 is a top plan view.

Figure 7 is a top plan view of an X-ray mask structure according to a further embodiment of the present invention.

Figures 8 and 9 show an X-ray mask structure according to a yet further embodiment of the present invention, wherein Figure 8 is a sectional view and Figure 9 is a to plan view.

## DESCRIPTION OF THE PREFERRED EMBODIMENTS

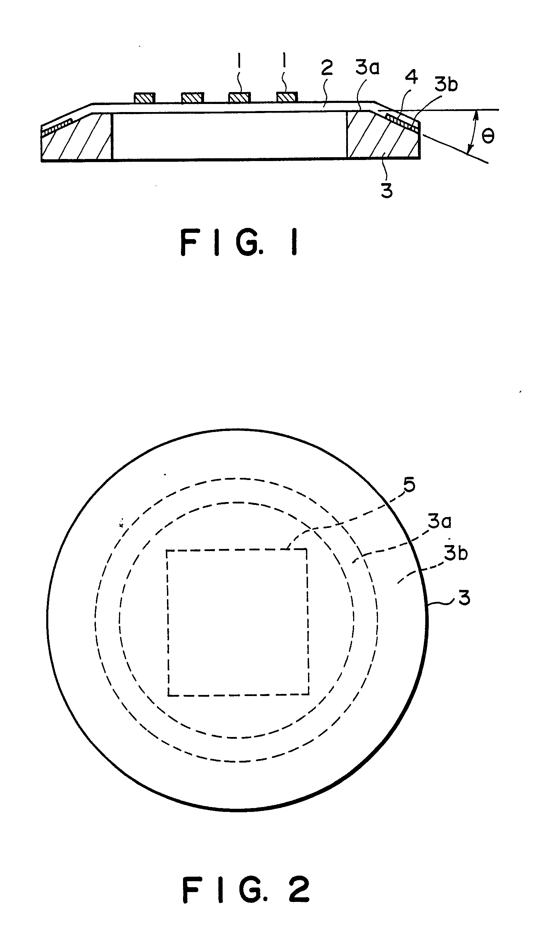

Figure 1 is a sectional view showing an X-ray mask structure according to an embodiment of the present invention. Figure 2 is a top plan view of the mask structure.

Supporting film 2 is stretched under tension and is bonded to a peripheral portion of a ring-like holding frame 3 by using an adhesive 4.

As for the supporting film 2, an organic thin film made of a material such as, for example, polyimide, polyamide or polyester, is usable. The thickness of the thin film is preferably within a range of 1 - 20 microns.

As for the ring-like holding frame 3, a material such as, for example, silicon, glass, quartz, phosphor bronze, brass, nickel or stainless steel is usable. No adhesive is applied to a topmost flat end face 3a of the frame 3. This is to avoid deterioration of the film flatness due to the intervention of any adhesive between the film and the flat end face. As regards the dimension of the ring-like holding frame 3, usually it has an outer diameter of 50 - 120 mm and an inner diameter of 15 - 80 mm. The topmost flat end face 3a has a width which is usually about 2 mm. The topmost flat end face 3a is finished by means of a super-precision lathe process or a lapping process to a surface roughness not greater than 0.5 $\mu$m.Ra. The flatness can be examined by using an interferometer of dual-beam type using two lights.

Experiments were made wherein the flatness of the entire supporting film 2 surface of an X-ray mask structure having a ring-like holding frame 3 (inner diameter: 80 mm) was measured by using a dual-beam interferometer and wherein the interrelation between the flatness of the supporting film 2 and a topmost flat end face 3a of the frame 3 was examined.

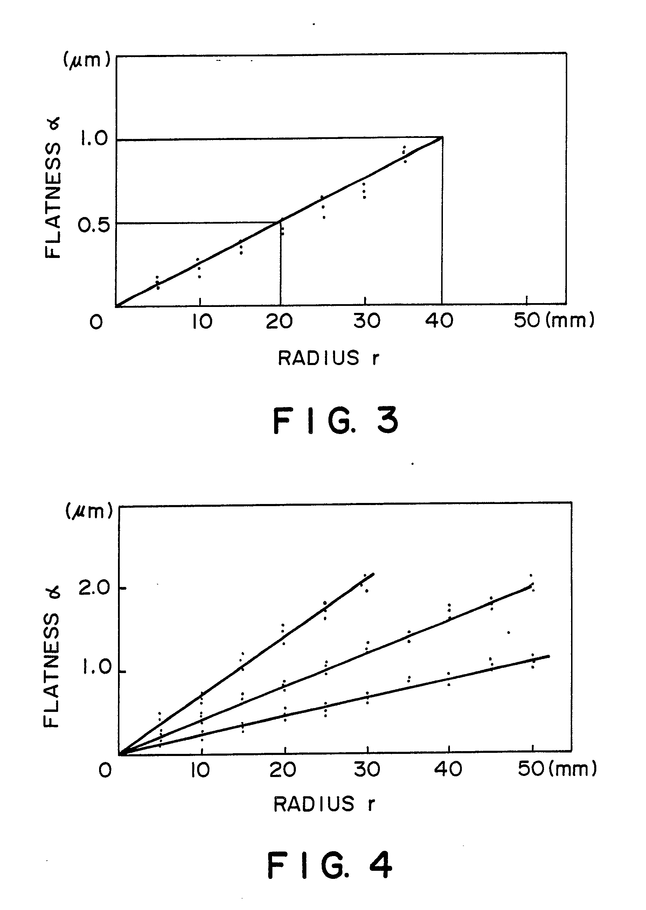

Figure 3 illustrates the interrelation between a radius r (mm) of an arbitrary region of the supporting film 2 and the flatness $\alpha$ (micron) in the region of the radius r.

It is seen from Figure 3 that, when an area 5 (Figure 2) of the pattern of the X-ray absorptive material is within the region of a radius 20 mm, the flatness $\alpha$ within that X-ray absorptive material pattern area 5 can be 0.5 micron.

Also it is seen that, where the topmost flat end portion 3a has been finished to a flatness t which is equal to 1 micron, the flatness $\alpha$ of the X-ray absorptive material pattern area 5 which is within the radius r is determined by the following equation:

$$\alpha = r/40 \times 1 \ (micron) \qquad (1)$$

This means that the finishing precision of the topmost flat end face 3a is not required to be one providing a flatness exactly the same as the flatness required within the X-ray absorptive material pattern area 5.

It will be readily understood from Figure 3 that the flatness $\alpha$ of the X-ray absorptive pattern area 5 can be determined by the flatness t (micron) of the topmost flat end face of the holding frame. That is, substituting the flatness "1 micron" of the topmost flat end face 3a in equation (1) by "t (micron)", since the interrelation as depicted in Figure 3 is established, then:

$\alpha = r/40 \times t$  (2)

Solving this equation in terms of t, since $\alpha$ determines the upper limit, then:

$t \leq 40/r \times \alpha$  (3)

Thus, in an example where the X-ray absorptive material pattern area 5 is within a radius 20 mm and a flatness of 1 micron is required for such X-ray absorptive pattern area 5, the flatness t of the topmost flat end face 3a may well be not greater than 2 microns. In other words, it is not necessary to finish the topmost flat end face 3a to a flatness not greater than 1 micron, as having been made conventionally.

This means that equation (3) can be rewritten as follows:

$\alpha < t \leq 40/r \times \alpha$  (4)

Figure 4 shows different examples wherein experiments were made by using different X-ray mask structures having ring-like holding frames of different inner diameters, to detect the interrelation between an arbitrary region having an arbitrary radius r and the flatness $\alpha$ within that region. It is seen from the results of those experiments that, where an inner diameter of a ring-like holding frame 3 is denoted by $\ell$, equation (4) can be rewritten as:

$\alpha < t \leq \ell/r \times \alpha$  (5)

Thus, once an inner diameter $\ell$ of a ring-like holding frame 3 and a radius r inclusive of an X-ray absorptive material pattern area as well as flatness $\alpha$ required for that area are given, the flatness t required for the topmost flat end face of the ring-like holding frame can be determined in accordance with equation (5).

In other words, it is sufficient that the topmost flat end face 3a is finished to a flatness t that satisfies equation (5). Since higher finishing precision necessitates a longer time and a higher cost, the simpleness of the present invention provides significant advantages such as substantial reduction in time necessary for the finishing and a resultant improvement in the throughput, as well as a substantial reduction in cost.

As regards the tension to be applied to the supporting film 2, if it is smaller than $10^7$ dyne/cm², the supporting film 2 will be flexed due to the effect of its weight and, therefore, the flatness $\alpha$ of the supporting film 2 will not be maintained at a predetermined. If, on the other hand, the tension is greater than $10^9$ dyne/cm², the supporting film 2 will cause plastic deformation and the strength of the film will decrease, resulting in a possibility of breaking. With a tension which is within a range of $10^7$ dyne/cm² to $10^9$ dyne/cm², equation (5) applies sufficiently.

The surface roughness of the topmost flat end face 3a is preferably not greater than 0.5 $\mu$m.Ra. If it is greater than 0.5 $\mu$m.Ra, due to such surface roughness there easily occurs wrinkles in a portion of the supporting film 2 adjacent to the topmost flat end face 3a, affecting against the flatness $\alpha$. Thus, equation (5) representing that the flatness $\alpha$ depends only on t, r and $\ell$ does not apply.

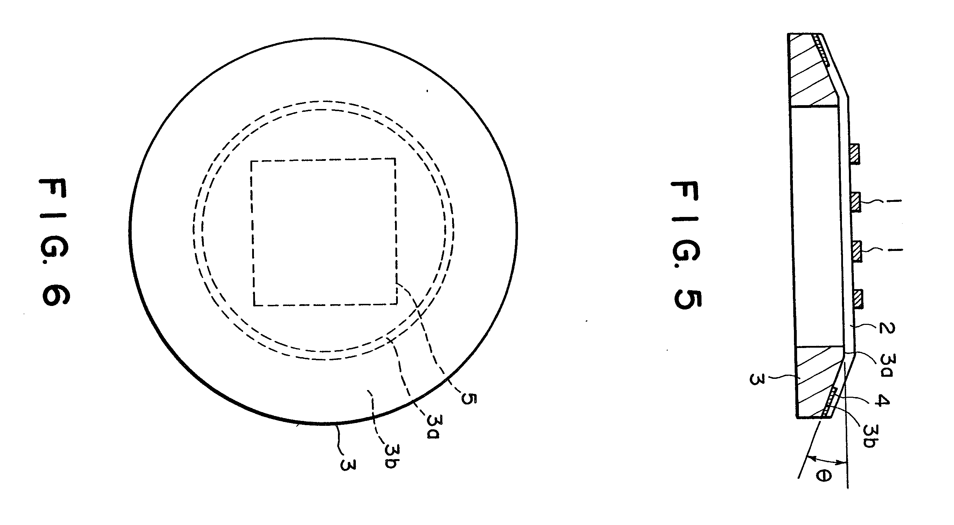

As shown in Figures 5 and 6 representing another embodiment of the present invention, the width of a topmost flat end face 3a may be made minimum within a range in which a predetermined flatness can be retained. For example, the width may be made not greater than 0.5 mm. This effectively reduces the possibility of creation of a clearance between a supporting film 2 and a ring-like holding frame 3. Therefore, it is possible to effectively avoid entrance of foreign particles or any developing liquid into between the supporting film 2 and the ring-like holding frame 3 during a cleaning process or a developing treatment of the mask structure. Consequently, undesirable local deterioration of the flatness of the topmost flat end face 3a of the ring-like holding frame can be prevented effectively.

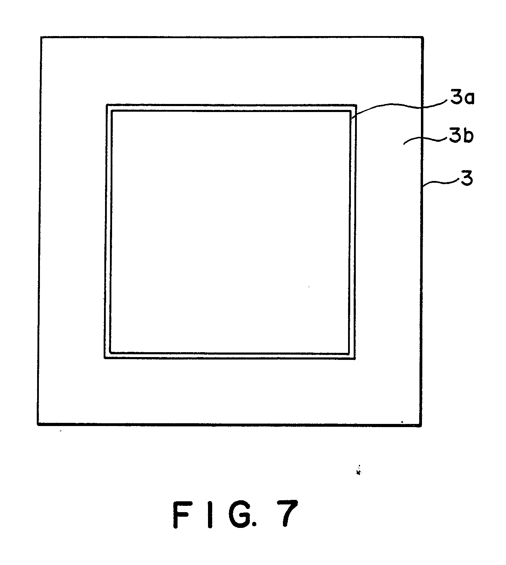

The shape of the holding frame 3 is not limited to a ring. For example, a rectangular shape such as shown in Figure 7 or a polygonal shape such as an octagonal shape, for example, are usable. Where an inner radius of such a holding frame is denoted by $\ell$ (mm), a radius of an inscribed circle inscribing the X-ray absorptive material pattern area is denoted by r (mm), and the flatness required for the X-ray absorptive material pattern area is denoted by $\alpha$ (micron), then the flatness t (micron) of the topmost flat end face of the holding frame can be given by:

$\alpha < t \leq r/\ell \times \alpha$

The material of the holding frame is not limited to the disclosed examples such as quartz, glass and brass, and any other materials may be used provided that a desired flatness is obtainable by the finishing treatment.

Specific examples will be described below.

Example 1

In this example, a flatness $\alpha$ required for an X-ray absorptive material pattern area 5 of a size 30 mm x 30 mm is not greater than 1 micron. The radius r of the X-ray absorptive pattern area 5 in that case is about 22 mm, since it is a half of the diagonal of the X-ray absorptive pattern area.

In this example, the ring-like holding frame 3 was made by using a stainless steel SUS304 of a thickness 5 mm and had an outer diameter of 85 mm and an inner diameter of 65 mm. The topmost flat end face 3a had a width of 2 mm. According to equation (5), the following relation is derived:

0.1 (micron) < t ≤ 32.5 (mm)/22 (mm) x 1 (micron) The flatness finishing precision for the topmost flat end face 3a should be not less than 0.1 micron and not greater than 1.47 micron. Thus, by means of a super-precision lathe process and a lapping treatment, the topmost flat end face 3a was finished to a finishing precision Ra = 0.1 micron and a flatness t = 1.3 micron.

To the resultant ring-like holding frame 3, a supporting film 2 ("Kapton film" having a thickness 7.5 microns, available from Toray Inc. Japan) was adhered at a bonding surface 3b, while a tension of $5 \times 10^7$ dyne/cm² was applied omnidirectionally to the supporting film.

Thus, a blank structure was obtained and, in accordance with a pattern forming process which is well-known in the art, an X-ray absorptive material pattern 1 was formed in the X-ray absorptive pattern area 5. Subsequently, the flatness α in the X-ray absorptive material pattern area 5 was measured by using a dual-beam interferometer. The result is that in a region of 30 mm x 30 mm a flatness of 0.9 micron was assured. Thus, it was confirmed that, as compared with the finishing of the topmost end face 3a to a flatness of 1 micron, the time can be reduced and, therefore, the throughput can be improved.

Example 2

In this example, a ring-like holding frame 3 of a similar shape as that in Example 1 was used, and the width of a topmost flat end face 3a thereof was 0.5 mm.

As in Example 1, the flatness finishing precision should be not less than 0.1 micron and not greater than 1.47 micron. Accordingly, by a similar procedure as in Example 1, the topmost flat end face 3a was finished with a finishing precision of Ra = 0.07 micron and a flatness t = 1.4 micron. To a bonding surface 3b of the resultant ring-like holding frame 3, a supporting film 2 of a thickness 7.5 microns was adhered while a tension of $6 \times 10^8$ dyne/cm² was applied to the supporting film.

In accordance with a well-known pattern forming process, an X-ray absorptive material pattern 1 was formed on the thus obtained blank structure and, thereafter, the flatness α in the X-ray absorptive pattern area 5 was measured by using a dual-beam interferometer. The result is that in a region of 30 mm x 30 mm a flatness of 0.82 micron was assured. Further, it was confirmed that, due to the reduced width (0.5 mm) of the topmost flat end face 3a, substantially no foreign particle entered into between the supporting film 2 and the topmost end face 3a and, as a result, a better flatness can be obtained throughout the X-ray absorptive material pattern area.

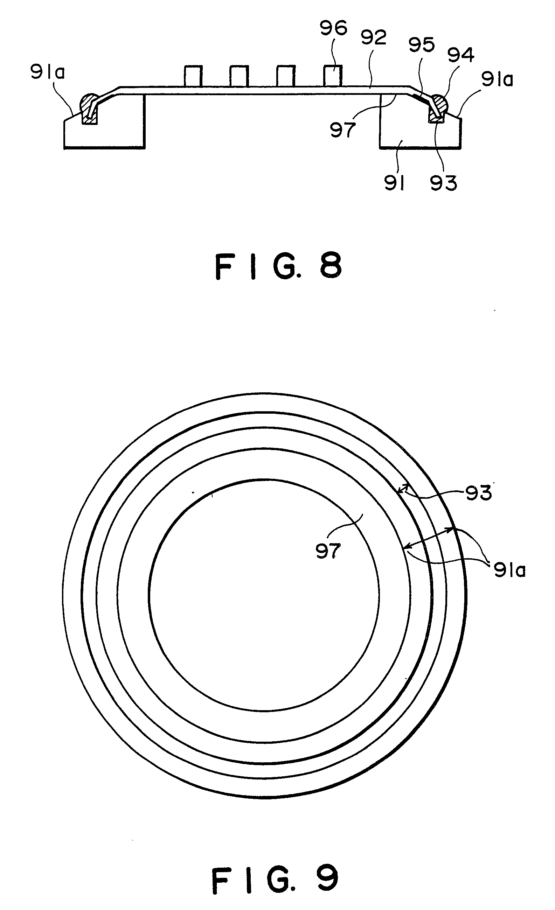

Figures 8 and 9 show an X-ray mask structure according to a further embodiment of the present invention, wherein Figure 8 is a sectional view and Figure 9 is a top plan view.

In Figures 8 and 9, denoted at 91 is a ring-like holding frame which is made of metal having a good heat conductivity such as, for example, iron, nickel, cobalt, brass, tungsten or molybdenum, or an alloy of two or more of them or, alternatively, it is made of pyrex, quartz or otherwise having a low thermal expansion rate. At an outer peripheral end portion of the holding frame 91, an inclined portion 91a which is inclined radially outwardly is formed. Also, in a region of the ring of the holding frame 91, a flat surface portion 97 having been ground to a super flatness is formed. Like the embodiments described hereinbefore, this flat surface portion 97 is effective to determine the flatness of a supporting film 92 which is to be adhered thereto under tension, as will be described later.

Denoted at 92 is the supporting film which is provided by an organic thin film having a good X-ray transmission factor and being made of a material such as polyimide, polyamide, polyester or Parylene, or an inorganic thin film made of a material such as boron nitride, silicon nitride, aluminum nitride, silicon carbide or titanium, or, alternatively, it is provided by a film made of a composite of two or more of them.

Denoted at 96 is an X-ray absorptive material formed into a predetermined pattern lying on the supporting film 92 surface. Denoted at 93 is a groove extending in the form of a circle concentric with the holding frame 91 which is circular in this embodiment. The groove 93 is formed at a position inwardly by about 3 mm, for example, of the outer periphery of the inclined portion 91a of the ring of the holding frame 91, and it has a channel-like cross-sectional shape, having a width of about 2 mm and a depth of about 1 mm.

In this embodiment, the supporting film 92 is adhered to the holding frame 91 in the following manner:

First, the supporting film 92 to which a tension of about $7 \times 10^8$ dyne/cm² being applied is contacted to and pressed against the flat surface portion 97 and the inclined portion 91a surface of the holding frame 91, the contacted supporting film being bonded to the holding frame with the setting of an adhesive 95 which is applied to the inclined portion 91a. In a particular example, a bonding agent ("Bond G10", available from Konishi Kabushiki Kaisha, Japan) was applied to a ring-like or circumferential portion of the inclined surface 91a of the holding frame 91, inside the groove 93 and having a width of about 5 mm. Subsequently, the peripheral edge portion of the supporting film 92 is cut along the outer circumferential edge of the holding frame 91 and, further, it is cut and shaped so that the peripheral edge portion of the supporting film 92 can be embedded within the groove 93. Thereafter, an adhesive material 94 such as an epoxy resin, for example, is injected into the groove 93 so that approximately a half depth of the groove is filled with the adhesive material. After this, the outer circumferential portion of the supporting film 92 is inserted into the groove 93. Subsequently, an additional amount of adhesive material 94 is applied to the groove 93 so that it provides a height substantially equal to the height of the inclined surface. By this, the supporting film 92 is fixedly secured to the holding frame 91.

Examples of the material of an adhesive usable in this embodiment are elastomeric adhesive, epoxy adhesive, emulsion adhesive, amine adhesive and polyimide adhesive. Thermosetting type, photo-setting type, solvent type or otherwise is usable. Particularly, use of an adhesive having high shear strength and good heat resistivity is preferable.

The groove 93 provided in the inclined portion 91a of the holding frame 91 of the present embodiment is not limited to one having a channel-like sectional shape. For example, a V-shaped groove, a U-shaped groove or a slit-like groove may be used. Further, in place of forming the groove 93 as having a depth in a direction perpendicular to the flat surface portion 97, the groove 93 may be formed with inclination, being inclined radially outwardly. This is desirable because it facilitates insertion of the outer peripheral portion of the supporting film 92.

It is not always necessary to form a groove 93 throughout the entire ring-like peripheral portion of the holding frame 91. It may be provided only a part of the peripheral portion.

While the invention has been described with reference to the structures disclosed herein, it is not confined to the details set forth and this application is intended to cover such modifications or changes as may come within the purposes of the improvements or the scope of the following claims.

## Claims

1. An X-ray mask for use in X-ray lithography, comprising:
a supporting film for supporting, in a region thereof having a radius r mm, a pattern made of an X-ray absorptive material; and
a holding frame member having an inner diameter $l$ mm, for holding said supporting film, said holding frame member having a topmost flat end face to which said supporting film is press-contacted;
wherein, where a flatness required for said region of the supporting film is denoted by $\alpha$ (micron), the topmost flat end face of said holding frame has been finished to a flatness t (micron) for which the following relation is satisfied:
$\alpha < t \leq l/r \times \alpha$

2. An X-ray mask according to Claim 1, wherein the topmost flat end face has been finished to a surface roughness not greater than 0.5 $\mu$m.Ra.

3. An X-ray mask according to Claim 1, wherein said supporting film is adhered to said holding frame member, while a tension in a range of $10^7 - 10^9$ dyne/cm$^2$ is applied to the supporting film.

4. An X-ray mask according to Claim 1, wherein said supporting film comprises an organic film.

5. An X-ray mask for use in X-ray lithography, comprising:
a holding frame member including (i) an inclined portion defined in a region of a circumferential edge portion of said holding frame member and being inclined radially outwardly and (ii) a groove formed in a part of said inclined portion; and
a supporting film for bearing a pattern and being stretched and adhered to said holding frame member, said supporting film being adhered to said holding frame member by using said inclined portion and said groove.

6. An X-ray mask according to Claim 5, wherein said supporting film has a portion which is inserted into said groove and wherein said portion of said supporting film is covered and fixed by an adhesive.

7. An X-ray mask according to Claim 6, wherein said supporting film comprises an organic film.

8. A method of manufacture of an X-ray mask for use in X-ray lithography, comprising the steps of:
providing a holding frame member having an inner diameter $l$ ;
providing a film for supporting an X-ray absorptive pattern in a region having a radius r;
determining a required flatness a of said region;
finishing the frame member to a flatness t where a $< t \leq a l/r$; and
securing the film to the frame member.

F I G. 1

F I G. 2

F I G. 3

F I G. 4

F I G. 5

F I G. 6

F I G. 7

F I G. 8

F I G. 9